# EUROPÄISCHE PATENTSCHRIFT

(11) **EP 1 181 854 B1**
(45) Veröffentlichungstag und Bekanntmachung des Hinweises auf die Patenterteilung: **04.12.2002**
(21) Anmeldenummer: 00940198.5
(22) Anmeldetag: 17.05.2000
(51) Int. Cl.: H05K 13/04

(54) **VERFAHREN ZUM BESTÜCKEN VON SUBSTRATEN MIT BAUELEMENTEN**
METHOD FOR FITTING A SUBSTRATE WITH COMPONENTS
PROCEDE POUR EQUIPER DES SUBSTRATS AVEC DES COMPOSANTS

(30) Priorität: 01.06.1999 DE 19925217
(43) Veröffentlichungstag der Anmeldung: 27.02.2002
(73) Patentinhaber: SIEMENS AKTIENGESELLSCHAFT, 80333 München (DE)
(72) Erfinder: PRÜFER, Martin, D-81379 München (DE)
(86) Internationale Anmeldenummer: DE0001568
(87) Internationale Veröffentlichungsnummer: WO00074462

(56) Entgegenhaltungen:
- EP-A- 0 779 777
- WO-A-98/37744
- US-A- 5 862 586

## Beschreibung

Die Erfindung bezieht sich auf ein Verfahren zum Bestücken von Substraten mit Bauelementen gemäß dem Oberbegriff des Patentanspruchs 1 oder 2.

Beim Bestücken von Substraten, insbesondere von Leiterplatten, mit Bauelementen, werden die Bauelemente aus Zuführeinheiten mit Hilfe von Bestückköpfen entnommen und vom Bestückkopf auf eine vorgegebene Position auf dem *Substrat* positioniert. Für eine hohe Bestückleistung (bestückte Substrate pro Zeiteinheit) sollen dabei möglichst viele Bauelemente pro Zeiteinheit auf den Substraten positioniert werden.

Aus WO 98/37744 ist dafür eine Vorrichtung zum Herstellen von elektrischen Baugruppen bekannt, die in einem zentralen Bereich zwei eng benachbarte, parallel verlaufende lineare Längsführungen aufweist, in denen Wagen entsprechend verfahrbar sind. Diese Wagen weisen jeweils einen Querträger zum Aufhängen jeweils eines Bestückkopfes auf. Es ergeben sich dabei zwei getrennte Bearbeitungsbereiche, die unabhängig voneinander bedient werden können. Dadurch wird eine große Bestückleistung der Vorrichtung ermöglicht.

Für eine noch höhere Bestückleistung werden Bestückautomaten in einer Linie zusammengestellt. Dabei weisen die verschiedenen Bestückautomaten unterschiedliche Vorräte an Bauelementtypen auf, und können für die jeweiligen Bauelementtypen besonders ausgebildet sein. Die in Linie angeordneten Bestückautomaten bilden somit in Linie angeordnete Bearbeitungsbereiche, wobei ein einzelner Bearbeitungsbereich jeweils aus einem Bestückkopf und dem Bestückkopf zugeordneten Zuführeinheiten mit bestimmten Bauelementtypen zugeordnet sind. Der gesamte Bestückinhalt für ein einzelnes Substrat wird dann auf beide Bearbeitungsbereiche aufgeteilt, das heißt auch die Zuführeinheiten werden auf die einzelnen Bearbeitungsbereiche aufgeteilt.

Um Nebenzeiten, wie das Einfahren des Substrats in den Bearbeitungsbereich nicht in die Bestückleistung eingehen zu lassen, werden zwei Transportvorrichtungen verwendet. Allerdings ist bei Substraten mit geringem Bestückinhalt (< rund 100 Bauelemente) zu berücksichtigen, daß die Nebenzeiten einen prozentual sehr hohen Anteil haben. Beispielsweise ist ein erneutes Vermessen der Referenzmarken auf dem Substrat nach dem Transport in den nächsten Bearbeitungsbereich erforderlich. Ein weiterer Effekt der bei geringen Bestückinhalten zu Leistungseinbußen führt, ist die Quantisierung aufgrund der am Kopf befindlichen Saugpipetten (z. B. 12 oder 18). Ein nur zum Teil gefüllter Bestückkopf muß trotzdem fast die gesamte Anzahl von Kopfzyklen fahren, wie ein vollständig gefüllter Bestückkopf.

Es ist daher die Aufgabe der Erfindung, ein Verfahren zum Bestücken von Substraten mit Bauelementen anzugeben, welches bei wenigen zu bestückenden Bauelementen und mehreren Bearbeitungsbereichen eine hohe Bestückleistung erzielt.

Die Aufgabe wird erfindungsgemäß gelöst durch ein Verfahren der eingangs genannten Art mit den kennzeichnenden Merkmalen des Anspruchs 1 oder 2.

Das erfindungsgemäße Verfahren bewirkt, daß bei einer Anzahl an zu bestückenden Bauelementen, die kleiner oder gleich der Anzahl der Zuführeinheiten im Bearbeitungsbereich ist, das komplette Substrat bereits auf dem ersten Bearbeitungsbereich bestückt wird. Dadurch fallen keine unnötigen Nebenzeiten an, wie das erneute Vermessen von Markierungen des Substrates im zweiten Bearbeitungsbereich, oder es ergeben sich reduzierte Nebenzeiten, wie durch die geringere Anzahl von zu fahrenden Bestückkopfzyklen.

Gemäß Anspruch 2 ist dabei zusätzlich vorgesehen, daß bei wenigen zu bestückenden Bauelementtypen zusätzlich theoretisch anhand des angenommenen Zeitverhaltens des Bestückkopfes ermittelt wird, ob sich durch das Bestücken in einem Arbeitsbereich eine Zeitersparnis ergibt und nur bei einer Zeitersparnis dann auch in einem Bearbeitungsbereich bestückt wird. Die Zeitersparnis ergibt sich in der Regel vor allem bei geringen Bestückinhalten, das heißt bei einer geringen zu bestückenden Anzahl von Bauelementen.

In der vorteilhaften Ausgestaltung des Verfahrens nach Anspruch 3 wird bei der Verwendung eines sogenannten Doppeltransportes mit zwei im wesentlichen parallel angeordneten Transportvorrichtungen sichergestellt, daß bei geringen Bestückinhalten zwei im wesentlichen voneinander entkoppelt arbeitende Bestücklinien eingesetzt werden. So wird in diesem Fall ein erstes Substrat im ersten Bearbeitungsbereich derart bestückt, daß im zweiten Bearbeitungsbereich keine Bestückung mehr erforderlich ist, während ein zweites Substrat auf der zweiten Transportvorrichtung im zweiten Bearbeitungsbereich bestückt wird.

Ist die Anzahl der zu bestückenden Bauelementtypen kleiner als die Anzahl der Zuführeinheiten, die auf einer Seite einer Transportvorrichtung angeordnet werden können, so ist es gemäß Anspruch 4 vorteilhaft, alle Bauelementtypen in Zuführeinheiten auf der Seite der Transportvorrichtungen anzuordnen, die der Transportvorrichtung näher liegt, auf der sich das zu bestückende Substrat befindet.

Befinden sich auf beiden Transportvorrichtungen Substrate mit geringem Bestückinhalt, so ist es vorteilhaft, gemäß Anspruch 5, daß die für die beiden Bestückprozesse vorrätig zu haltenden Bauelementtypen jeweils auf der Seite der Transportvorrichtungen angeordnet sind, die der Transportvorrichtung, auf der sich das jeweils zu bestückende Substrat befindet, näher liegt.

Anhand eines Ausführungsbeispiels wird die Erfindung in den Figuren der Zeichnung näher erläutert. Dabei zeigen:
- Figur 1: eine schematische Draufsicht auf eine Linie zum Bestücken von Bauelementen mit zwei Bearbeitungsbereichen bei einer großen Anzahl an zu bestückenden Bauelementen,
- Figur 2: eine schematische Draufsicht auf eine Linie von Bearbeitungsbereichen bei einer geringen Anzahl an zu bestückenden Bauelementen,
- Figur 3: ein Flußdiagramm eines ersten Ausführungsbeispiels des erfindungsgemäßen Verfahrens und
- Figur 4: ein Flußdiagramm eines zweiten Ausführungsbeispiels des erfindungsgemäßen Verfahrens.

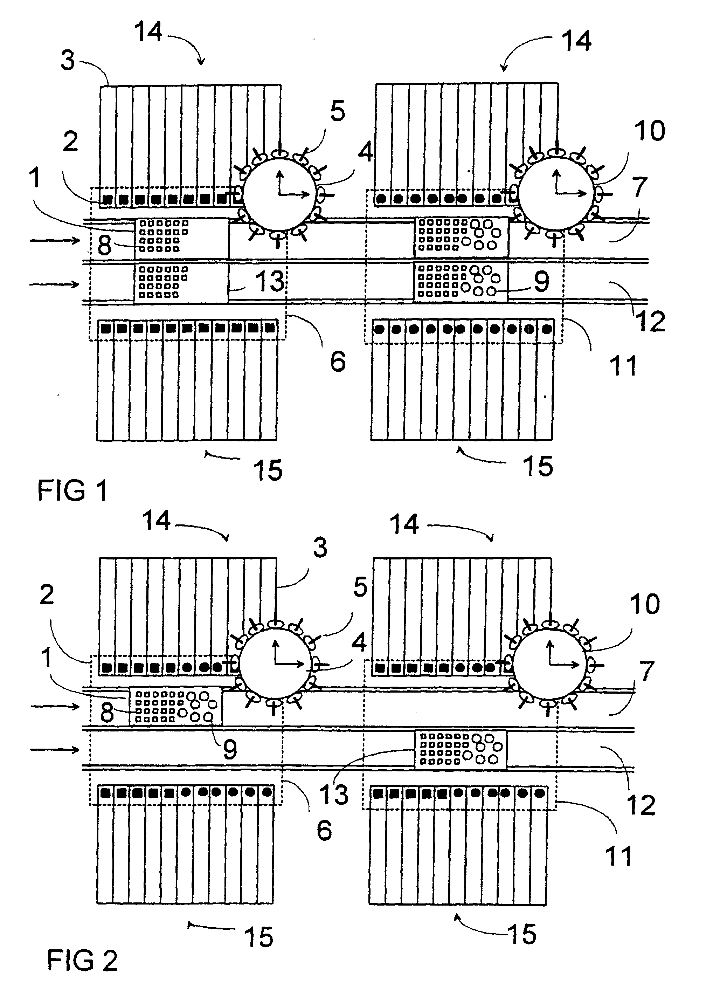

In Figur 1 ist eine schematische Draufsicht auf eine Linie von Bearbeitungsbereichen 6, 11 dargestellt. Im ersten Bearbeitungsbereich 6 wird ein erstes Substrat 1 mit Bauelementen 2 bestückt, die in Zuführeinheiten 3 zur Verfügung gestellt werden. Ein Bestückkopf 4 nimmt mit Haltevorrichtungen 5, beispielsweise Saugpipetten, die Bauelemente 2 aus den Zuführeinheiten 3 auf, transportiert sie durch eine Bewegung im wesentlichen parallel zur Oberfläche des Substrats 1 in eine vorgegebene Position oberhalb des Substrats 1 und setzt sie dort auf das Substrat 1 auf. Der Bestückkopf 4 ist dabei innerhalb des Bearbeitungsbereiches 6 beweglich. Über eine erste Transportvorrichtung 7 wird das erste Substrat 1 in den ersten Bearbeitungsbereich 6 gefahren, mit einer ersten Gruppe 8 von Bauelementen bestückt und nach dem Bestückprozeß in einen zweiten Bearbeitungsbereich 11 transportiert. Die beiden Bearbeitungsbereiche 6, 11 sind daher in einer Linie angeordnet. Im zweiten Bearbeitungsbereich 11 wird mit Hilfe eines zweiten Bestückkopfes 10 analog das Substrat 1 mit einer zweiten Gruppe 9 an Bauelementen 2 aus Zuführeinheiten 3 bestückt. In Figur 1 ist darüber hinaus ein zweites Substrat 13 dargestellt, welches sich auf einer zweiten Transportvorrichtung 12 ebenfalls durch die beiden Bearbeitungsbereiche 6, 11 bewegt und in den jeweiligen Bearbeitungsbereichen 6, 11 mit Hilfe des ersten Bestückkopfes 4 und des zweiten Bestückkopfes 10 mit Bauelementen 2 in einer ersten Gruppe 8 und einer zweiten Gruppe 9 bestückt wird. Um weitere Bauelemente zu bestücken, können in der Linie weitere Bearbeitungsbereiche vorgesehen sein. In jeder Zuführeinheit 3 sind dabei Bauelemente 2 eines bestimmten Bauelementtypes, beispielsweise bestimmter Widerstände, bestimmter integrierter Schaltungen oder anderer bestimmter elektronischer Bauelemente vorrätig. Durch die Aufteilung des gesamten Bestückinhalts in zwei Bearbeitungsbereiche ist es vor allem bei wenigen zu bestükkenden Bauelementen nachteilig, daß in jedem Bearbeitungsbereich beispielsweise die Position des einzelnen Substrats 1 bestimmt werden muß, bevor der eigentliche Bestückprozeß beginnen kann. Bei wenigen zu bestückenden Bauelementen 2 tritt außerdem häufig der Fall auf, daß der Bestückkopf 4, der in diesem Beispiel insgesamt zwölf Saugpipetten 5 aufweist, häufig nicht vollständig gefüllt den Weg von den Zuführeinheiten 3 zum Substrat 1 zurücklegen muß. Diese Zeit von der Zuführeinheit 3 zum Substrat 1 geht allerdings entscheidend in die Größe der Bestückleistung, das heißt die Anzahl der bestückten Bauelemente pro Zeiteinheit, ein.

In der Figur 2 ist dargestellt, daß der gesamte Bestückinhalt, das heißt sowohl die erste Gruppe 8 als auch die zweite Gruppe 9, bei wenigen zu bestückenden Bauelementen nur in einem der beiden Bearbeitungsbereiche bestückt wird. Nicht dargestellt, aber möglich ist die Verwendung der jeweils leeren Plätze auf den Transportvorrichtungen 7,12 in den jeweiligen Bearbeitungsbereichen als Puffer für weitere Substrate, um Wechselzeiten möglichst klein zu halten.

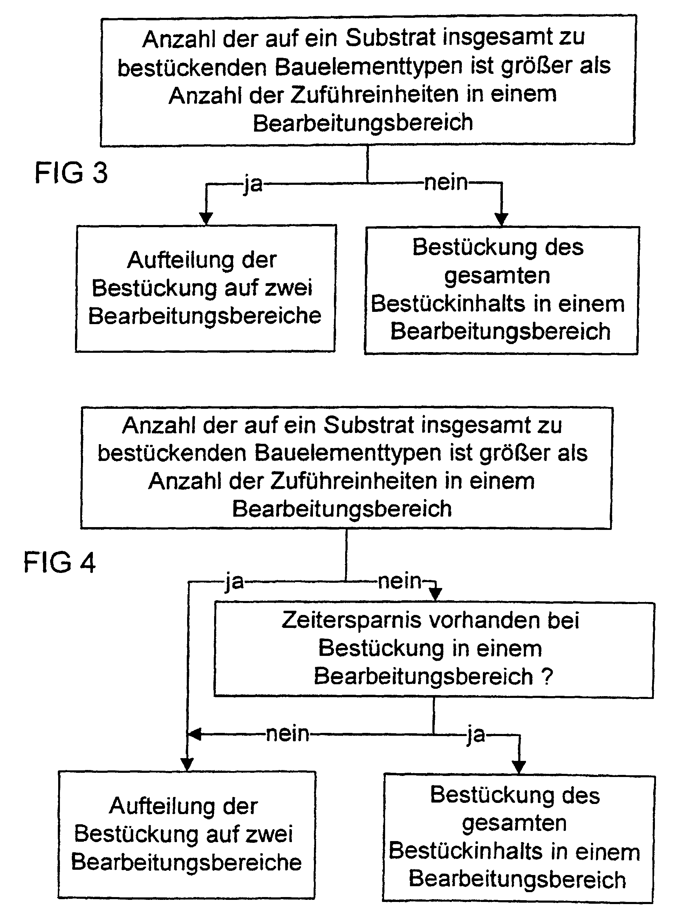

Wie in Figur 3 anhand des Flußdiagramm schematisch dargestellt ist, wird in einem ersten Ausführungsbeispiel vor dem Bestückprozeß ermittelt, ob die Anzahl der auf ein Substrat insgesamt zu bestückenden Bauelementtypen größer ist als die Anzahl der Zuführeinheiten in einem Bearbeitungsbereich. Nur wenn diese Anzahl größer ist, wird die Bestückung auf zwei Bearbeitungsbereiche aufgeteilt, ansonsten erfolgt die Bestückung des gesamten Bestückinhalts in einem Bearbeitungsbereich.

Ein weiteres Ausführungsbeispiel ist in Figur 4 in Form eines weiteren Flußdiagramms dargestellt. Dabei ist berücksichtigt, daß der Zeitvorteil durch das Bestücken in nur einem Bearbeitungsbereich dann besonders groß ist, wenn die Anzahl der zu bestückenden Bauelemente klein ist, da in diesem Fall die Nebenzeiten besonders effektiv reduziert sind. Vor der Bestükkung wird daher im Rahmen einer sogenannten Rüstoptimierung unter Berücksichtigung der theoretischen Verfahrzeiten des Bestückkopfes ermittelt, ob bei wenigen Bauelementtypen eine Zeitersparnis bei Aufteilung des Bestückinhalts auf zwei Bearbeitungsbereiche erzielt wird oder nicht. In Abhängigkeit dieses Ergebnisses erfolgt dann die Bestückung in einem oder zwei Bearbeitungsbereichen.

Bei der Verwendung von einer ersten Transportvorrichtung 7 und einer zweiten Transportvorrichtung 12 werden die beiden Transportvorrichtungen sowie die beiden Bearbeitungsbereiche 6, 11 durch dieses Verfahren im wesentlichen entkoppelt. Durch das Verfahren können daher in vorteilhafter Weise in einer Bestücklinie, ohne aufwendige Umbauten, sowohl Substrate mit hohem Bestückinhalt, dann aufgeteilt auf mehrere Bearbeitungsbereiche, als auch Substrate mit geringem Bestückinhalt, dann erfolgt die Bestückung nur in einem Bearbeitungsbereich, mit hoher Bestückleistung produziert werden.

Eine weitere Erhöhung der Bestückleistung läßt sich erzielen, wenn die Anzahl der auf das Substrat 1, 13 zu bestückenden Bauelementtypen 2 kleiner oder gleich der Anzahl der in einer Gruppe 14, 15 auf einer Seite der Transportvorrichtung 7, 12 angeordneten Zuführeinheiten 3 ist. Werden dann alle zu bestückenden Bauelementtypen 2 in Zuführeinheiten 3 in einer ersten Gruppe 14 direkt neben die erste Transportvorrichtung 7 aufgebaut, so verfährt der Bestückkopf nur den kurzen Weg zwischen der Zuführeinheit 3 und dem Substrat 1. Entsprechend kann beim zweiten Substrat 13 im zweiten Bearbeitungsbereich 11 die Bestückung ausschließlich über die Inhalte der zweiten Gruppe 15 von Zuführeinheiten 3 erfolgen.

## Patentansprüche

1. Verfahren zum Bestücken von Substraten (1,13) mit Bauelementen (2) an mindestens zwei in einer Linie aufeinanderfolgend angeordneten Bearbeitungsbereichen (6,11), die durch mindestens eine Transportvorrichtung (7,12) für die Substrate (1,13) verbunden sind und jeweils mindestens einen Bestückkopf (4,10) sowie jeweils eine Anzahl an Zuführeinheiten (3) aufweisen, wobei jede Zuführeinheit (3) mehrere Bauelemente (2) eines Baüelementtyps vorrätig hält,
**dadurch gekennzeichnet,**
**daß** die Anzahl der unterschiedlichen auf ein Substrat (1,13) zu bestückenden Bauelementtypen mit der Anzahl der Zuführeinheiten (3) verglichen wird,
**daß** bei einer geringeren oder gleichen Anzahl der zu bestükkenden Bauelementtypen das Substrat (1,13) in einem Bearbeitungsbereich (6,11) vollständig bestückt wird und
**daß** bei einer größeren Anzahl an zu bestückenden Bauelementtypen das Substrat (1,13) an den mindestens zwei aufeinanderfolgenden Bearbeitungsbereichen (6,11) bestückt wird.

2. Verfahren zum Bestücken von Substraten (1,13) mit Bauelementen (2) an mindestens zwei in einer Linie aufeinanderfolgend angeordneten Bearbeitungsbereichen (6,11), die durch mindestens eine Transportvorrichtung (7,12) für die Substrate (1,13) verbunden sind und jeweils mindestens einen Bestückkopf (4,10) sowie jeweils eine Anzahl an Zuführeinheiten (3) aufweisen, wobei jede Zuführeinheit (3) mehrere Bauelemente (2) eines Bauelementetyps vorrätig hält,
**dadurch gekennzeichnet,**
**daß** die Anzahl der unterschiedlichen auf ein Substrat (1,13) zu bestückenden Bauelementtypen mit der Anzahl der Zuführeinheiten (3) verglichen wird,
**daß** bei einer geringeren oder gleichen Anzahl der zu bestükkenden Bauelementtypen die theoretische Zeitdifferenz zwischen dem Ablauf einer vollständigen Bestückung in einem der bearbeitungsbereiche (6,11) und dem Ablauf einer Bestückung an den mindestens zwei Bearbeitungsbereichen (6,11) mit Hilfe eines theoretischen Zeitverhaltens des Bestückkopfes ermittelt wird,
**daß** das Substrat (1,13) bei einer positiven Zeitdifferenz in einem Bearbeitungsbereich (6,11) vollständig bestückt wird und bei einer negativen Zeitdifferenz an den mindestens zwei Bearbeitungsbereichen (6,11) bestückt wird und
**daß** bei einer größeren Anzahl an zu bestückenden Bauelementtypen das Substrat (1,13) an den mindestens zwei aufeinanderfolgenden Bearbeitungsbereichen (6,11) bestückt wird.

3. Verfahren zum Bestücken von Substraten (1,13) mit Bauelementen (2) nach einem der Ansprüche 1 oder 2,
**dadurch gekennzeichnet,**
**daß** ein erster Teil der Substrate (z.B. 1) auf einer ersten Transportvorrichtung (7) durch die Linie der Bearbeitungsbereiche (6,11) transportiert wird und ein zweiter Teil der Substrate (z.B.13) auf einer zweiten, zur ersten im wesentlichen parallel angeordneten, Transportvorrichtung (12) durch die Linie der Bearbeitungsbereiche (6,11) transportiert wird und
im Fall der geringeren oder gleichen Anzahl der zu bestückenden Bauelementtypen der erste Teil der Substrate (z.B.1) im ersten Bearbeitungsbereich (6) vollständig bestückt wird und der zweite Teil der Substrate (z.B.13) im zweiten Bearbeitungsbereich (6) vollständig bestückt wird.

4. Verfahren zum Bestücken von Substraten (1,13) mit Bauelementen (2) nach Anspruch 3,
**dadurch gekennzeichnet,**
**daß** eine erste Gruppe (14) der Zuführeinheiten (3) in den Bearbeitungsbereichen (6,11) auf einer der beiden Seiten der zwei Transportvorrichtungen (7,12) angeordnet wird und der Rest der Zuführeinheiten (14) in einer zweiten Gruppe (15) von Zuführeinheiten (3) auf der gegenüberliegenden Seite der Transportvorrichtungen (7,12) angeordnet wird,
**daß** die Anzahl der Bauelementtypen, die auf eines der auf der ersten Transportvorrichtung (7) befindlichen Substrate (z.B.1) zu bestücken sind, mit der jeweiligen Anzahl der in der ersten Gruppe (14) vorhandenen Zuführeinheiten (3) verglichen wird,
**daß** bei einer geringeren oder gleichen Anzahl der Bauelementtypen die erste Gruppe (14) aus den Zuführeinheiten (3) mit den zu bestückenden Bauelementtypen zusammengestellt und auf der der ersten Transportvorrichtung (7) näheren Seite angeordnet wird.

5. Verfahren zum Bestücken von Substraten (1,13) mit Bauelementen (2) nach Anspruch 4,
**dadurch gekennzeichnet,**
**daß** die Anzahl der Bauelementtypen, die auf eines der auf der zweiten Transportvorrichtung (12) befindlichen Substrate (z.B.13) zu bestücken sind, mit der jeweiligen Anzahl der in der zweiten Gruppe (15) vorhandenen Zuführeinheiten (3) verglichen wird,
**daß** bei einer geringeren oder gleichen Anzahl der Bauelementtypen die zweite Gruppe (15) aus den Zuführeinheiten (3) mit den zu bestückenden Bauelementtypen zusammengestellt und auf der der zweiten Transportvorrichtung (12) näheren Seite angeordnet wird.

## Claims

1. Method of fitting substrates (1, 13) with components (2) in at least two processing areas (6, 11) which are arranged one after another in a line, are connected by at least one transport device (7, 12) for the substrates (1, 13) and in each case have at least one fitting head (4, 10) and in each case a number of feed units (3), each feed unit (3) keeping a plurality of components (2) of a component type in stock,
**characterized**
**in that** the number of different component types to be fitted onto a substrate (1, 13) is compared with the number of feed units (3),
**in that** in the event of a lower or equal number of component types to be fitted, the substrate (1, 13) is fitted completely in a processing area (6, 11) and
**in that** in the event of a greater number of component types to be fitted, the substrate (1, 13) is fitted in the at least two processing areas (6, 11) following one another.

2. Method of fitting substrates (1, 13) with components (2) in at least two processing areas (6, 11) which are arranged one after another in a line, are connected by at least one transport device (7, 12) for the substrates (1, 13) and in each case have at least one fitting head (4, 10) and in each case a number of feed units (3), each feed unit (3) keeping a plurality of components (2) of a component type in stock,
**characterized**
**in that** the number of different component types to be fitted onto a substrate (1, 13) is compared with the number of feed units (3),
**in that** in the event of a lower or equal number of component types to be fitted, the theoretical time difference between the sequence of complete fitting in one of the processing areas (6, 11) and the sequence of fitting in the at least two processing areas (6, 11) is determined with the aid of a theoretical time response of the fitting head,
**in that**, in the event of a positive difference, the substrate (1, 13) is fitted completely in one processing area (6, 11) and, in the event of a negative time difference, is fitted in the at least two processing areas (6, 11) and
**in that** in the event of a greater number of component types to be fitted, the substrates (1, 13) is fitted in the at least two processing areas (6, 11) following one another.

3. Method of fitting substrates (1, 13) with components (2) according to either of Claims 1 and 2,
**characterized**
**in that** a first proportion of the substrates (e.g. 1) is transported through the line of processing areas (6, 11) on a first transport device (7), and a second proportion of the substrates (e.g. 13) is transported through the line of processing areas (6, 11) on a second transport device (12) arranged substantially parallel to the first and
in the case of the lower or equal number of component types to be fitted, the first proportion of the substrates (e.g. 1) is completely fitted in the first processing area (6) and the second proportion of the substrates (e.g. 13) is completely fitted in the second processing area (6).

4. Method of fitting substrates (1, 13) with components (2) according to Claim 3,
**characterized**
**in that** a first group (14) of feed units (3) in the processing areas (6, 11) is arranged on one of the two sides of the two transport devices (7, 12), and the rest of the feed units (14) in a second group (15) of feed units (3) is arranged on the opposite side of the transport devices (7, 12),
**in that** the number of component types which are to be fitted onto one of the substrates (e.g. 1) located on the first transport device (7) is compared with the respective number of feed units (3) present in the first group (14),
**in that** in the event of a lower or equal number of component types, the first group (14) of the feed units (3) is put together with the component types to be fitted and arranged on the side closer to the first transport device (7).

5. Method of fitting substrates (1, 13) with components (2) according to Claim 4,
**characterized**
**in that** the number of component types which are to be fitted onto one of the substrates (e.g. 13) located on the second transport device (12) is compared with the respective number of feed units (3) present in the second group (15),
**in that** in the event of a lower or equal number of component types, the second group (15) of feed units (3) is put together with component types to be fitted and arranged on the side closer to the second transport device (12).

## Revendications

1. Procédé pour équiper des substrats (1, 13) avec des composants (2) sur au moins deux zones de traitement (6, 11) disposés successivement en une ligne et qui sont reliées par au moins un dispositif de transport (7, 12) des substrats (1, 13) et présentent chacune au moins une tête d'équipement (4, 10) ainsi que chacune un certain nombre d'unités d'amenée (3), chaque unité d'amenée (3) contenant en réserve plusieurs composants (2) d'un type de composants,
**caractérisé en ce que**
le nombre des différents types de composants à installer sur un substrat (1, 13) est comparé au nombre des unités d'amenée (3),
**en ce que** lorsque le nombre des types de composants à installer est inférieur ou égal, le substrat (1, 13) est complètement équipé dans une seule zone de traitement (6, 11), et
**en ce que** lorsque le nombre des types de composants à installer est plus élevé, le substrat (1, 13) est équipé sur les deux zones de traitement successives (6, 11) au moins présentes.

2. Procédé pour l'équipement de substrats (1, 13) avec des composants (2) sur au moins deux zones de traitement (6, 11) disposées l'une après l'autre en une ligne, qui sont reliées par au moins un dispositif de transport (7, 12) de substrats (1, 13) et qui présentent chacune au moins une tête d'équipement (4, 10) ainsi que chacune un certain nombre d'unités d'amenée (3), chaque unité d'amenée (3) contenant en réserve plusieurs composants (2) d'un type de composants,
**caractérisé en ce que**
le nombre des différents types de composants à installer sur un substrat (1, 13) est comparé au nombre des unités d'amenée (3),
**en ce que** lorsque le nombre des types de composants à installer est inférieur ou égal, la différence théorique de temps entre le déroulement d'une installation complète dans l'une des zones de traitement (6, 11) et le déroulement d'un équipement sur les deux zones de traitement (6, 11) au moins présentes est déterminé à l'aide du temps théorique de la tête d'équipement,
**en ce que** lorsque la différence de temps est positive, le substrat (1, 13) est complètement équipé dans une seule zone de traitement (6,11), et lorsque la différence de temps est négative, il est équipé sur les deux zones de traitement (6, 11) au moins présentes, et
**en ce que** lorsque le nombre des types de composants à installer est supérieur, le substrat (1, 13) est équipé sur les deux zones de traitement (6, 11) successives au moins présentes.

3. Procédé pour l'équipement de substrats (1, 13) avec des composants (2) selon l'une des revendications 1 ou 2,
**caractérisé en ce que**
une première partie des substrats (par exempte 1) est transportée sur un premier dispositif de transport (7) à travers la ligne des zones de traitement (6, 11) et une deuxième partie des substrats (par exemple 13) est transportée sur un deuxième dispositif de transport (12) disposé essentiellement en parallèle au premier, à travers la ligne des zones de traitement (6, 11), et
lorsque le nombre des types d'éléments à installer est inférieur ou égal, la première partie des substrats (par exemple 1) est entièrement équipée dans la première zone de traitement (6) et la deuxième partie des substrats (par exemple 13) est enitèrement équipée dans la deuxième zone de traitement (6).

4. Procédé pour l'équipement de substrats (1, 13) avec des composants (2) selon la revendication 3, **caractérisé en ce que**
un premier groupe (14) d'unités d'amenée (3) est disposé dans les zones de traitement (6, 11) sur l'un des deux côtés des deux dispositifs de transport (7, 12) et le reste des unités d'amenée (14) est disposé en un deuxième groupe (15) d'unités d'amenée (3) sur le côté opposé des dispositifs de transport (7, 12),
**en ce que** le nombre des types de composants qui doivent être installés sur l'un des substrats (par exemple 1) situé sur le premier dispositif de transport (7) est comparé aux nombres respectifs des unités d'amenée (3) présentes dans le premier groupe (14), et
**en ce que** lorsque le nombre des types de composants est inférieur ou égal, le premier groupe (14) d'unités d'amenée (3) contenant les types de composants à installer est rassemblé et disposé sur le côté le plus proche du premier dispositif de transport (7).

5. Procédé pour l'équipement de substrats (1, 13) avec des composants (2) selon la revendication 4, **caractérisé en ce que**
le nombre des types de composants qui doivent être installés sur l'un des substrats qui se trouve sur le deuxième dispositif de transport (12) est comparé au nombre respectif des unités d'amenée (3) présentes- dans le deuxième groupe (15), et
**en ce que** lorsque le nombre des types de composant est inférieur ou égal, le deuxième groupe (15) est constitué des unités d'amenée (3) contenant les types de composants à installer et est disposé sur le côté le plus proche du deuxième dispositif de transport (12).
